(19) Europäisches Patentamt
European Patent Office
Office européen des brevets

(11) **EP 1 394 561 B1**

(12) **EUROPÄISCHE PATENTSCHRIFT**

(45) Veröffentlichungstag und Bekanntmachung des Hinweises auf die Patenterteilung:
**18.08.2010  Patentblatt 2010/33**

(51) Int Cl.:
***G01R 31/36*** *(2006.01)*

(21) Anmeldenummer: **03013525.5**

(22) Anmeldetag: **13.06.2003**

(54) **Verfahren zur Ermittlung der entnehmbaren Ladungsmenge einer Speicherbatterie und Überwachungseinrichtung für eine Speicherbatterie**

Method for determining the remaining charge of a battery and monitoring circuit for a battery

Procédé pour déterminer la charge résiduelle d'une batterie et arrangement pour surveiller une batterie

(84) Benannte Vertragsstaaten:
**AT BE BG CH CY CZ DE DK EE ES FI FR GB GR HU IE IT LI LU MC NL PT RO SE SI SK TR**

(30) Priorität: **31.08.2002  DE 10240329**

(43) Veröffentlichungstag der Anmeldung:
**03.03.2004  Patentblatt 2004/10**

(73) Patentinhaber: **VB Autobatterie GmbH & Co. KGaA**
**30419 Hannover (DE)**

(72) Erfinder: **Koch, Ingo, Dipl.-Ing.**
**31789 Hameln (DE)**

(74) Vertreter: **Gerstein, Hans Joachim et al**
**Gramm, Lins & Partner GbR**
**Theodor-Hauss-Strasse 1**
**38122 Braunschweig (DE)**

(56) Entgegenhaltungen:
**US-A- 4 453 129    US-B1- 6 252 377**

**Beschreibung**

Die Erfindung betrifft ein Verfahren zur Ermittlung der entnehmbaren Ladungsmenge einer Speicherbatterie sowie eine Überwachungseinrichtung für eine Speicherbatterie mit Messmitteln zur Messung von Batteriespannungen und Batterieströmen und mit Auswertemitteln.

Es besteht ein Bedarf, die entnehmbare Ladungsmenge einer Speicherbatterie während des Betriebs abzuschätzen.

Hierzu ist in dem US-Patent 5,761,072 ein Verfahren zur Bestimmung der Kapazität einer Speicherbatterie beschrieben, bei dem durch einen Filter ein schneller Strom und durch Mittelwertbildung mittels Integration ein langsamer Strom ermittelt wird. Die Werte für den schnellen und langsamen Strom werden in eine sogenannte Peukertbeziehung eingesetzt, um eine Kapazität für einen schnellen Strom und für einen langsamen Strom zu ermitteln. Diese Kapazitäten werden gewichtet und hieraus eine Gesamtkapazität berechnet.

In der DE 694 23 918 T2 ist eine Vorrichtung zur Anzeige des Entleerungsgrades einer Batterie beschrieben, bei der periodisch Messwerte z. B. von Leerlaufspannung oder Innenimpedanz erfasst werden. Diese Messwerte werden über einen Tiefpass gefiltert und der Mittelwert davon bestimmt. Wenn der Mittelwert einen Schwellwert überschreitet wird eine Entleerungs-Warnanzeige erzeugt.

In der DE 691 31 276 T2 ist ein elektronischer Tester zum Bewerten der prozentualen Energiekapazität einer Batterie oder einer Batteriezelle offenbart. In diesem Verfahren wird der dynamische Leitwert bestimmt und zu einem Referenzleitwert ins Verhältnis gesetzt, der dem dynamischen Leitwert einer Batterie oder Batteriezelle mit 100 prozentiger Kapazität entspricht.

Mit diesen vorbekannten Verfahren oder Vorrichtungen kann zwar der Ladezustand einer neuwertigen Batterie ermittelt werden. Eine Aussage über die noch entnehmbare Ladungsmenge einer gebrauchten Batterie insbesondere bei kleinen Strömen kann jedoch nicht getroffen werden.

Das Problem bei Speicherbatterien ist nämlich, dass die bei vollgeladener Speicherbatterie entnehmbare Ladungsmenge durch verschiedene Ursachen abnehmen kann. Einer gebrauchten Speicherbatterie kann somit nicht mehr die gleiche Ladungsmenge entnommen werden wie im Neuzustand. Diese Ursachen können z. B. bei Bleiakkumulatoren der Verlust an aktiver Masse durch Abschlammung, Sulfatation oder ähnliches sein.

Wird z. B. der Ladezustand einer Speicherbatterie durch Messung der Ruhespannung ermittelt, wie dies z. B. bei einem Bleiakkumulator möglich ist, so kann mit diesem Wert keine Aussage darüber getroffen werden, welche Ladungsmenge $Q_R$ der vollgeladenen Speicherbatterie noch entnommen werden kann, wenn diese nicht mehr im Neuzustand ist. Der Grund hierfür ist, dass zwar in diesem Fall der Ladezustand ein Maß für die der Säure entnehmbare Ladungsmenge ist, die Ladungsmenge, die der aktiven Masse noch entnommen werden kann, korreliert jedoch nur im Neuzustand mit der Ladungsmenge in der Säure.

Bei einer Definition des Ladezustands (SOC) als Quotient der Differenz zwischen Nennladungsmenge und entnommener Ladungsmenge zur Nennladungsmenge

$$SOC = \frac{Nennladungsmenge - entnommener\ Ladungsmenge}{Nennladungsmenge}$$

gibt der Ladezustand (SOC) ebenfalls keine Aussage über die entnehmbare Ladungsmenge $Q_R$.

Der Ladezustand nach diesen Definitionen gibt somit keine Aussage über die einer gebrauchten Speicherbatterie tatsächlich entnehmbare Ladungsmenge $Q_R$.

Aus den US-Patenten 5,721,688 und 5,572,136 sind Vorrichtungen und Verfahren bekannt, bei denen ein relativ kleiner zeitveränderlicher Strom einer Speicherbatterie aufgeprägt und die zeitabhängige Spannungsantwort der Speicherbatterie beobachtet und ausgewertet wird. Aus der Spannungsantwort kann die Leitfähigkeit der Speicherbatterie ermittelt werden. Im Betrieb ist es jedoch nicht immer möglich und erwünscht, einen separaten Messstrom aufzuprägen.

In dem US-Patent 6,252,377 ist ein Verfahren zur Ermittlung der Restladung beschrieben, bei dem Strom- und Spannungssignale jeweils tiefpassgefiltert durch Integration des Stroms bestimmt und mit einem Grenzwert verglichen werden. Ein Integrator ermittelt die Ladeleistung aus einer Tabelle in Abhängigkeit von der Temperatur und der Restladung. Es sind mehrere Tiefpassfilter für ein einziges Stromsignal mit verschiedenen Zeitkonstanten vorgesehen. Die Auswahl der Zeitkonstanten hängt von dem Spannungsausgang ab.

Aufgabe der Erfindung war es daher, ein verbessertes Verfahren zur Ermittlung der einer Speicherbatterie im voligeladenen Zustand entnehmbaren Ladungsmenge $Q_R$ sowie eine Überwachungseinrichtung für eine Speicherbatterie zu schaffen, mit dem die entnehmbare Ladungsmenge $Q_R$ einer gebrauchten Speicherbatterie mit einfachen Mitteln möglichst genau ermittelbar ist.

Die Aufgabe wird mit dem gattungsgemäßen Verfahren erfindungsgemäß gelöst durch

- Bestimmen der Batteriespannung und des Batteriestroms über mindestens ein Zeitintervall,

- Glätten der gemessenen Batteriespannungs- U(t) und Batteriestromverläufe I(t) mit mindestens zwei unterschiedlichen Glättungsmaßen,

- Bilden der Spannungsdifferenzen $\Delta U_{23}(t)$ der mit einem ersten Glättungsmaß geglätteten Batteriespannungen und der mit einem zweiten Glättungsmaß geglätteten Batteriespannungen, wobei das zweite Glättungsmaß eine größere Glättung als das erste Glättungsmaß bewirkt,

- Bilden der Stromdifferenzen $\Delta I_{23}(t)$ der mit einem ersten Glättungsmaß geglätteten Batterieströme und der mit einem zweiten Glättungsmaß geglätteten Batterieströme, wobei das zweite Glättungsmaß eine größere Glättung als das erste Glättungsmaß bewirkt,

- Berechnen von Kennwerten aus den Quotienten der Spannungsdifferenzen und den Stromdifferenzen,

- Verrechnen jeweils der Kennwerte eines Zeitintervalls zu einem Intervall-Kennwert und durch Bilden des Mittelwertes der Kennwerte eines Zeitintervalls und

- Bestimmen der entnehmbaren Ladungsmenge aus mindestens einen Intervall-Kennwert für mindestens ein Zeitintervall in Abhängigkeit von dem Ladezustand der Speicherbatterie und der Batterietemperatur.

Es wurde erkannt, dass durch einfache rechnerische Auswertung der gemessenen Batteriespannungen und Batterieströme einer Speicherbatterie im Betrieb die entnehmbare Ladungsmenge ermittelt werden kann. Dies wird dadurch erreicht, dass durch geeignete Glättung der Batteriespannungen und Batterieströme eine Referenzspannung und ein Referenzstrom durch die Wahl einer großen Zeitkonstanten als Glättungsmaß erzeugt wird, von dem die Abweichung des mit einer kleineren Zeitkonstanten geglätteten Batteriestroms und Batteriespannung bewertet wird. Hierzu müssen lediglich die Batteriespannung und Batterieströme über mindestens ein Zeitintervall fortlaufend gemessen und rechnerisch ausgewertet werden.

Die Glättung erfolgt vorzugsweise durch Filterung mit Zeitkostanten, durch Mittelwertbildung, insbesondere des gleitenden Mittelwerts, oder ähnlichem.

Aus den berechneten Kennwerten wird ein Mittelwert als Intervall-Kennwert berechnet. Der Mittelwert kann auch ein gleitender Mittelwert oder Median etc. sein.

Vorteilhaft ist es, wenn die Kennwerte nur dann berechnet oder zur Bestimmung des Intervall-Kennwertes hinzugezogen werden, wenn bestimmte Bedingungen erfüllt sind. Die Ermittlung der entnehmbaren Ladungsmenge erfolgt somit nur auf der Basis zulässiger Kennwerte.

Eine Bedingung kann sein, dass der Betrag der Stromdifferenz $\Delta I_{23}(t)$ kleiner als ein festgelegter zweiter Grenzwert ist.

Alternativ oder zusätzlich hierzu kann eine weitere Bedingung sein, dass der Betrag der Stromdifferenz $\Delta I_{12}(t)$ des mit dem ersten Glättungsmaß geglätteten Batteriestroms und des mit einem zweiten Glättungsmaß geglätteten Batteriestroms kleiner als ein festgelegter ersten Grenzwert ist, wobei das zweite Glättungsmaß eine größere Glättung als das erste Glättungsmaß bewirkt.

Als weitere Bedingung kann vorgesehen sein, dass die mit dem ersten Glättungsmaß geglätteten Batterieströme größer als ein dritter Grenzwert und kleiner als ein vierter Grenzwert sind.

Es kann weiterhin vorgeschrieben sein, dass der Betrag der Stromdifferenz $\Delta I_{23}(t)$ größer als ein festgelegter fünfter Grenzwert und/oder der Betrag der Stromdifferenz $\Delta I_{12}(t)$ des mit der zweiten Zeitkonstanten gefilterten Batteriestroms und des mit einer ersten Zeitkonstanten gefilterten Batteriestroms größer als ein festgelegter sechster Grenzwert ist.

Vorzugsweise liegt der erste und der zweite Grenzwert in einem Bereich des 30-stündigen bis 80-stündigen Stroms und entspricht vorzugsweise etwa dem 50-stündigen Strom. Der dritte Grenzwert entspricht vorzugsweise etwa dem 10-stündigen Strom und der vierte Grenzwert etwa dem 30-stündigen Strom, wobei eine Toleranz von etwa 50% noch zu vergleichbaren Ergebnissen führt,

Für Bleiakkumulatoren mit ca. 70 Ah hat sich ein erster Grenzwert im Bereich von etwa 1 A, ein zweiter Grenzwert im Bereich von etwa 1 A, ein dritter Grenzwert von etwa -5 A und ein vierter Grenzwert im Bereich von etwa -2 A als vorteilhaft herausgestellt. Die Grenzwerte sind nur als ungefähre Richtgrößen zu verstehen, da das Verfahren von der Batterie-Bauart und -Größe abhängt.

Besonders vorteilhaft ist es, wenn die zulässigen Kennwerte, die die oben genannten Bedingungen erfüllen, in einem Zeitintervall integriert werden. Die Zeiten, in denen zulässige Kennwerte vorliegen, werden ebenfalls integriert, um eine Zeitdauer des Zeitintervalls zu berechnen. Der Intervall-Kennwert wird dann als Quotient aus dem durch Integration der zulässigen Kennwerte berechneten integrierten Kennwertes des Zeitintervalls und der Zeitdauer des Zeitintervalls berechnet.

Die Intervall-Kennwerte werden vorzugsweise in Abhängigkeit von dem Betriebszustand der Speicherbatterie gewichtet. Beispielsweise können für den Entladebetrieb der Speicherbatterie andere Wichtungsfaktoren als für den Ladebetrieb vorgesehen sein.

Es hat sich als vorteilhaft herausgestellt, wenn die entnehmbare Ladungsmenge aus dem mindestens einen Intervall-Kennwert in Abhängigkeit von dem Ladezustand der Speicherbatterie und der Batterietemperatur beispielsweise mit Hilfe empirisch oder rechnerisch ermittelter Kennfelder oder mit geeigneten Formeln bestimmt wird.

Für die praxisnahe Anwendung ist es vorteilhaft, ein Kennfeld für Neuzustandintervall-Kennwerte einer Speicherbatterie im Neuzustand in Abhängigkeit von Ladezuständen und Batterietemperaturen anzulernen.

Zur Ermittlung der entnehmbaren Ladungsmenge einer Speicherbatterie im Betrieb wird dann eine Maßzahl J aus einem Intervall-Kennwert bei einem ermittelten Ladezustand und einer gemessenen Batterietemperatur und aus dem angelernten Neuzustand-Intervall-Kennwert für den ermittelten Ladezustand und der gemessenen Batterietemperatur berechnet. Die entnehmbare Ladungsmenge wird dann in Abhängigkeit von der Maßzahl J und dem Ladezustand und der Batterietemperatur ermittelt. Die Intervall-Kennwerte werden somit in Bezug auf Neuzustand-Intervall-Kennwerte ausgewertet.

Die Maßzahl J kann beispielsweise die Differenz oder das Verhältnis von dem Intervall-Kennwert und dem Neuzustand-Intervall-Kennwert sein.

Die Erfindung wird nachfolgend anhand der beigefügten Zeichnungen näher erläutert. Es zeigen:

Figur 1 - Diagramm von mit verschiedenen Zeitkonstanten gefilterten Batteriestromverläufen sowie mit festgelegten Grenzwerten;

Figur 2 - Flussdiagramm des erfindungsgemäßen Verfahrens zur Ermittlung der entnehmbaren Ladungsmenge;

Figur 3 - Diagramm der entnehmbaren Ladungsmenge über den Intervall-Kennwert bei zwei unterschiedlichen Temperaturen.

Mit dem erfindungsgemäßen Verfahren ist es nunmehr möglich durch Auswertung der im Betrieb der Speicherbatterie messbaren Strom- und Spannungsprofile die entnehmbare Ladungsmenge $Q_R$ zu ermitteln.

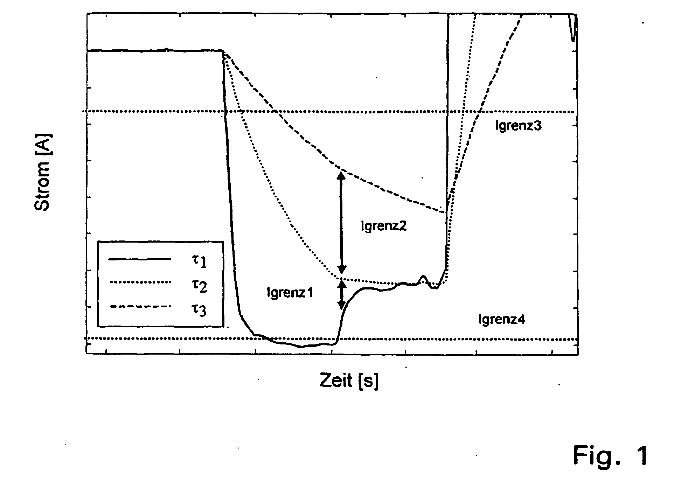

Hierzu wird die Batteriespannung U(t) und der Batteriestrom I(t) mit einer geeigneten zeitlichen Auflösung von vorzugsweise weniger als 1 s gemessen und die Batteriespannungswerte U(t) und die Batteriestromwerte I(t) beispielsweise mit mindestens zwei Tiefpassfiltern mit unterschiedlichen Zeitkonstanten $\tau$ geglättet. Eine zweite Zeitkonstante $\tau_2$ als erstes Glättungsmaß sollte hierbei kleiner als eine dritte Zeitkonstante $\tau_3$ als zweites Glättungsmaß sein. Die Glättung kann auch durch Mittelwertbildung, beispielsweise gleitende Mittelwertbildung über verschiedene Zeitfenster, oder ähnlichen erfolgen. Die Figur 1 lässt entsprechende, mit unterschiedlichen Zeitkostanten $\tau$ geglättete Batteriestromverläufe erkennen.

Anschließend werden für jeweils ein Zeitintervall Spannungsdifferenzen $\Delta U_{23}(t)$ aus der Differenz der mit der zweiten Zeitkonstanten $\tau_2$ gefilterten Batteriespannungen U(t) und der mit der dritten Zeitkonstanten $\tau_3$ gefilterten Batteriespannungen U(t) berechnet. Ebenso werden die Stromdifferenzen $\Delta I_{23}(t)$ aus der Differenz der mit der zweiten Zeitkonstanten $\tau_2$ gefilterten Batterieströme I(t) und der mit der dritten Zeitkonstanten $\tau_3$ gefilterten Batterieströme U(t) berechnet.

Aus den Quotienten der Spannungsdifferenzen $\Delta U_{23}(t)$ und der Stromdifferenzen $\Delta I_{23}(t)$ wird dann ein Kennwert K(t) als Funktion der Zeit jeweils begrenzt auf die Zeitintervalle $\Delta t$ berechnet. Aus den Kennwerten K(t) jeweils eines Zeitintervalls $\Delta t$ wird dann ein Intervall-Kennwert Km vorzugsweise durch Mittelwertbildung berechnet und die entnehmbare Ladungsmenge $Q_R$ als Funktion des Intervall-Kennwertes Km bestimmt. Dies wird durch die folgenden Gleichungen deutlicher:

$$Q_R(\Delta t) = f(Km(\Delta t)) = f\left(\frac{1}{T}\int\frac{(U_{\tau3}(t) - U_{\tau2}(t))}{(I_{\tau3}(t) - I_{\tau2}(t))}dt\right)$$

Die Bestimmung der entnehmbaren Ladungsmenge $Q_R$ beruht hierbei nur auf zulässigen Kennwerten K(t), die mindestens eine der nachfolgenden Bedingungen erfüllen:

a) Der Betrag der Stromdifferenz $\Delta I_{12}(t)$ des mit der zweiten Zeitkonstanten $\tau_2$ gefilterten Batteriestroms I(t) und des mit einer ersten Zeitkonstanten $\tau_1$ als drittes Glättungsmaß gefilterten Batteriestroms I(t) ist kleiner als ein festgelegter erster Grenzwert $I_{grenz1}$.

b) Der Betrag der Stromdifferenz $\Delta I_{23}(t)$ ist kleiner als ein festgelegter zweiter Grenzwert $I_{grenz2}$.

c) Die mit der zweiten Zeitkonstanten $\tau_2$ gefilterten Batterieströme I(t) sind größer als ein festgelegter dritter Grenzwert $I_{grenz3}$ und kleiner als ein festgelegter vierter Grenzwert $I_{grenz4}$.

Optional kann auch noch festgelegt sein, dass der Betrag der Stromdifferenz $\Delta I_{23}(t)$ größer als ein festgelegter fünfter Grenzwert $I_{grenz5}$ und der Betrag der Stromdifferenz $\Delta I_{12}(t)$ größer als ein festgelegter sechster Grenzwert $I_{grenz6}$ ist.

Die Bedingungen können durch folgende Gleichung ausgedrückt werden:

$$I_{grenz5} < \left| I_{\tau3}(t) - I_{\tau2}(t) \right| < I_{grenz2}$$

$$I_{grenz6} < \left| I_{\tau2}(t) - I_{\tau1}(t) \right| < I_{grenz1}$$

$$I_{grenz3} < I_{\tau2}(t) < I_{grenz4}.$$

Für Starter-Bleiakkumulatoren der Größe von 70 Ah haben sich Größenordnungen für den ersten Grenzwert von $I_{grenz1}$ = 1 A, für den zweiten Grenzwert von $I_{grenz2}$= 1 A, für den dritten Grenzwert von $I_{grenz3}$= -5 A und für den vierten Grenzwert von $I_{grenz4}$=-2 A als vorteilhaft herausgestellt. Die Strom-Grenzwerte selbst sind neben der Batteriegröße auch bauartabhängig.

Die Figur 1 lässt ein Diagramm von mit einer ersten Zeitkonstanten $\tau_1$, einer zweiten Zeitkonstante $\tau_2$ und einer dritten Zeitkonstanten $\tau_3$ geglätteten Batteriestromwerten I(t) über die Zeit mit festgelegten Grenzwerten $I_{grenz1}$, $I_{grenz2}$, $I_{grenz3}$ und $I_{grenz4}$ erkennen. Es wird deutlich, dass durch die Festlegung der Grenzwerte die Kennzahl K im wesentlichen nur im mittleren und hinteren Bereich der ersten abklingenden Flanke des Strompulses vorgenommen wird, da nur dort die Grenzwertbedingungen erfüllt sind.

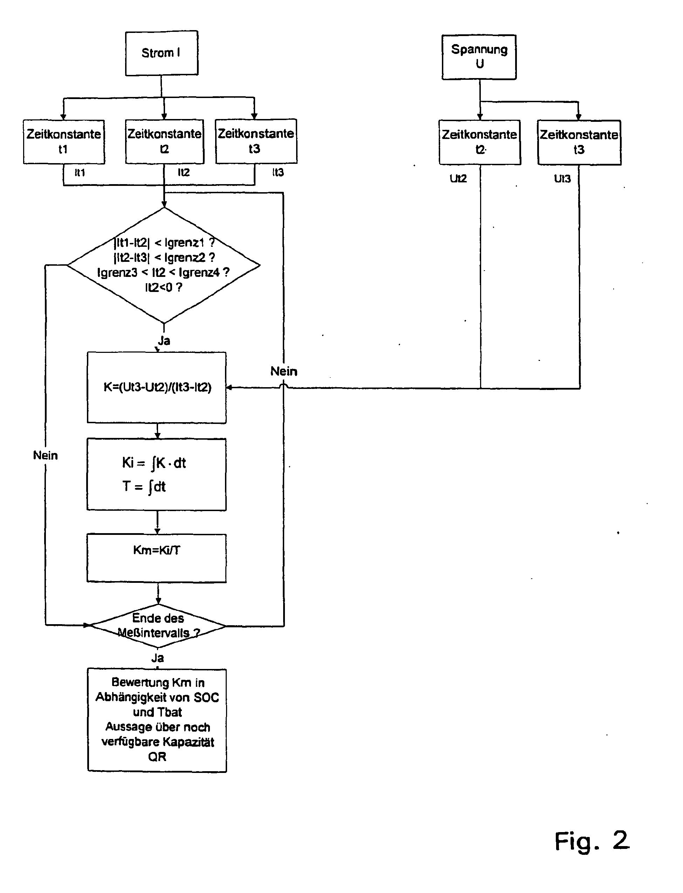

Die Figur 2 lässt ein mögliches Flussdiagramm für das erfindungsgemäße Verfahren zur Ermittlung der entnehmbaren Ladungsmenge $Q_R$ erkennen. Hierbei wird die Auswertung beschränkt auf die Zeiten, in denen die Batterie entladen wird.

Es wird deutlich, dass die Batterieströme I(t) mit drei Tiefpassfiltern unterschiedlicher Zeitkonstanten $\tau_1$, $\tau_2$, $\tau_3$ gefiltert werden. Es wird überprüft, ob die gefilterten Stromwert $I_{\tau1}(t)$, $I_{\tau2}(t)$, $I_{\tau3}(t)$ die oben beschriebenen Bedingungen erfüllt, d. h. dass

$$\left| I_{\tau1} - I_{\tau2} \right| < I_{grenz1},$$

$$\left| I_{\tau2} - I_{\tau3} \right| < I_{grenz2},$$

$$I_{grenz3} < I_{\tau2} < I_{grenz4},$$

$$I_{\tau2} < 0$$

ist. Wenn dies der Fall ist, wird aus den gedämpften Stromwerten 1(t) und den mit einem Tiefpassfilter mit einer zweiten Zeitkonstante $\tau_2$ und einem Tiefpassfilter mit einer dritten Zeitkonstante $\tau_3$ gedämpften Spannungswerten $U_{\tau2}(t)$ und $U_{\tau3}(t)$ ein Kennwert K(t) nach der Formel

$$K(t) = \frac{(U_{\tau3}(t) - U_{\tau2}(t))}{(I_{\tau3}(t) - I_{\tau2}(t))}$$

berechnet. Aus den Kennwerten K(t) eines Zeitintervalls $\Delta t$ wird beispielsweise durch Integralbildung ein integrierter Kennwert Ki

$$Ki = \int K \cdot dt$$

und durch Integration der Zeiten, in denen die Bedingungen erfüllt sind, die Zeit dauer T des Zeitintervalls

$$T = \int dt$$

bestimmt.

Dann wird der Intervall-Kennwert

$$Km = \frac{Ki}{T}$$

als Mittelwert der zulässigen Kennwerte K(t) berechnet.

Am Ende eines Zeitintervalls $\Delta t$ wird der Intervall-Kennwert Km vorzugsweise in Abhängigkeit von dem Ladezustand SOC und der Batterietemperatur $T_{Bat}$ bewertet und die entnehmbare Ladungsmenge $Q_R$ bestimmt.

Die Bestimmung der entnehmbaren Ladungsmenge $Q_R$ kann mit Hilfe von vorgegebenen empirisch oder rechnerisch ermittelten Kennfeldern in Abhängigkeit des Ladezustands SOC und der Batterietemperatur $T_{Bat}$ vorgenommen werden.

Bei bekannter Abhängigkeit von dem Ladezustand und der Batterietemperatur $T_{Bat}$ ist es auch möglich, den Kennwert K(t) entsprechend zu korrigieren. Auch ist es sinnvoll, den Kennwert K(t) in Abhängigkeit von der Betriebssituation der Speicherbatterie zu gewichten. Beispielsweise können Zeitintervalle $\Delta t$, in denen die Speicherbatterie geladen wird, anders gewichtet werden als Zeitintervalle $\Delta t$, in denen die Batterie entladen wird.

Um aus dem Intervall-Kennwert Km auf die entnehmbare Ladungsmenge $Q_R$ schließen zu können, wird vorzugsweise ein Neuwert-Intervall-Kennwert $Km_{neu}$ in Abhängigkeit von Ladezuständen SOC und Batterietemperaturen $T_{Bat}$ ermittelt und als Kennwert festgehalten. Die Ermittlung kann durch Anlernen eines Kennfeldes erfolgen.

Im Betrieb wird dann eine Maßzahl J aus der Differenz oder dem Verhältnis des Intervall-Kennwertes Km und des Neuwert-Intervall-Kennwertes $Km_{neu}$ für die jeweils vorliegenden Ladezustände SOC und Batterietemperaturen $T_{Bat}$ bestimmt. Die Neuwert-Intervall-Kennwerte $Km_{neu}$ werden somit mit den ermittelten Intervall-Kennwerten Km bei gleichem Ladezustand SOC und Batterietemperatur $T_{Bat}$ verglichen. Die entnehmbare Ladungsmenge $Q_R$ wird dann als Funktion des Ladezustands SOC, der Batterietemperatur $T_{Bat}$ und der Maßzahl J beispielsweise mit Hilfe von Kennfeldern bestimmt.

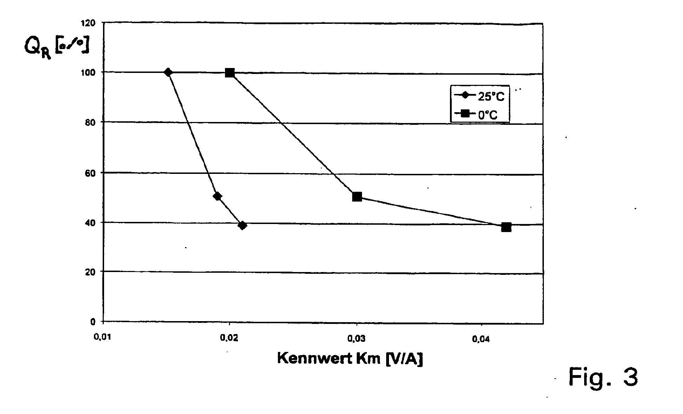

Die Figur 3 lässt ein Diagramm einer Starterbatterie mit 70 Ah der über den Kennwert Km aufgetragenen entnehmbaren Ladungsmenge $Q_R$ in Abhängigkeit von der Batterietemperatur $T_{Bat}$ von 0° und 25° erkennen. Der Ladezustand SOC beträgt 70%.

Es wird deutlich, dass ein eindeutiger Zusammenhang zwischen der entnehmbaren Ladungsmenge $Q_R$ und dem Kennwert Km besteht, sofern die Batterietemperatur $T_{Bat}$ und der Ladezustand SOC bekannt ist. Entsprechende Kennfelder können für weitere Ladezustände SOC und Batterietemperaturen $T_{Bat}$ ermittelt und abgespeichert werden. Aufgrund dieser Daten kann dann aus den Intervall-Kennwerten Km, die nach dem oben beschriebenen erfindungsgemäßen Verfahren berechnet wurden, die entnehmbare Ladungsmenge $Q_R$ bestimmt werden.

**Patentansprüche**

1. Verfahren zur Ermittlung der entnehmbaren Ladungsmenge ($Q_R$) einer Speicherbatterie,

   - Bestimmen der Batteriespannung (U(t)) und des Batteriestroms (I(t)) über mindestens ein Zeitintervall ($\Delta t$),

   **gekennzeichnet durch**

   - Glätten der gemessenen Batteriespannungs- (U(t)) und Batteriestromverläufe (I(t)) mit mindestens zwei unterschiedlichen Glättungsmaßen,
   - Bilden der Spannungsdifferenzen ($\Delta U_{23}(t)$) der mit einem ersten Glättungsmaß geglätteten Batteriespannungen (U(t)) und der mit einem zweiten Glättungsmaß geglätteten Batteriespannungen (U(t)), wobei das zweite Glättungsmaß eine größere Glättung als das erste Glättungsmaß bewirkt,
   - Bilden der Stromdifferenzen ($\Delta I_{23}(t)$) der mit einem ersten Glättungsmaß geglätteten Batterieströme (I(t)) und der mit einem zweiten Glättungsmaß geglätteten Batterieströme (I(t)), wobei das zweie Glättungsmaß eine größere Glättung als das erste Glättungsmaß bewirkt,
   - Berechnen von Kennwerten (K(t)) aus den Quotienten der Spannungsdifferenzen ($\Delta U_{23}(t)$) und den Stromdifferenzen ($\Delta I_{23}(t)$),
   - Verrechnen jeweils der Kennwerte (K(t)) eines Zeitintervalls ($\Delta(t)$) zu einem Intervall-Kennwert (Km) **durch** Bilden des Mittelwertes der Kennwerte (K(t) eines Zeitintervalls ($\Delta t$) und
   - Bestimmen der entnehmbaren Ladungsmenge ($Q_R$) aus mindestens einem Intervall-Kennwert (Km) für mindestens ein Zeitintervall ($\Delta t$), in Abhängigkeit von dem Ladezustand (SOC) der Speicherbatterie und der Batterietemperatur ($T_{Bat}$).

2. Verfahren nach Anspruch 1, **dadurch gekennzeichnet, dass** das Glätten durch Filtern mit unterschiedlichen Zeitkonstanten ($\tau$), erfolgt, wobei eine zweite Zeitkonstante ($\tau_2$) als erstes Glättungsmaß größer als eine dritte Zeitkonstante ($\tau_3$) als zweites Glättungsmaß ist.

3. Verfahren nach Anspruch 1 oder 2, **dadurch gekennzeichnet, dass** das Glätten mindestens teilweise durch Mittelwertbildung erfolgt.

4. Verfahren nach einem der Ansprüche 1 bis 3, **dadurch gekennzeichnet, dass** die Kennwerte (K(t)) nur dann berechnet oder zur Bestimmung des Intervall-Kennwertes (Km) hinzugezogen werden, wenn der Betrag der Stromdifferenz ($\Delta I_{23}(t)$) kleiner als ein festgelegter zweiter Grenzwert ($I_{grenz2}$) ist.

5. Verfahren nach Anspruch 4, **dadurch gekennzeichnet, dass** der zweite Grenzwert ($I_{grenz2}$) im Bereich des 30-stündlgen bis 80-stündigen Stroms liegt, und vorzugsweise etwa dem 50-stündigen Strom der Speicherbatterie entspricht.

6. Verfahren nach einem der Ansprüche 1 bis 5, **dadurch gekennzeichnet, dass** die Kennwerte (K(t)) nur dann berechnet oder zur Bestimmung des Intervall-Kennwertes (Km) hinzugezogen werden, wenn der Betrag der Stromdifferenz ($\Delta I_{12}(t)$) des mit dem ersten Glättungsmaß geglätteten Batteriestroms (I(t)) und des mit einem zweiten Glättungsmaß geglätteten Batteriestroms (I(t)) kleiner als ein festgelegter erster Grenzwert ($I_{grenz1}$) ist, wobei das zweite Glättungsmaß eine größere Glättung als das erste Glättungsmaß bewirkt.

7. Verfahren nach Anspruch 6, **dadurch gekennzeichnet, dass** der erste Grenzwert ($I_{grenz1}$) im Bereich des 30-stündigen bis 80-stündigen Stroms liegt, und vorzugsweise etwa dem 50-stündigen Strom der Speicherbatterie entspricht.

8. Verfahren nach einem der vorhergehenden Ansprüche, **dadurch gekennzeichnet, dass** die Kennwerte (K(t)) nur dann berechnet oder zur Bestimmung des Intervall-Kennwertes (Km) hinzugezogen werden, wenn die mit dem ersten Glättungsmaß geglätteten Batterieströme (I(t)) größer als ein dritter Grenzwert ($I_{grenz3}$) und kleiner als ein vierter Grenzwert ($I_{grenz4}$) sind.

9. Verfahren nach Anspruch 8, **dadurch gekennzeichnet, dass** der dritte Grenzwert ($I_{grenz3}$) etwa der 10-stündige Strom und der vierte Grenzwert ($I_{grenz4}$) etwa der 30-stündige Strom ist.

10. Verfahren nach einem der Ansprüche 6 bis 9, **gekennzeichnet durch** Integration der zulässigen Kennwerte (K(t))

in einem Zeitintervall ($\Delta t$) zur Berechnung eines integrierten Kennwertes (Ki) für das Zeitintervall ($\Delta t$) und Integration der Zeiten, in denen zulässige Kennwerte (K(t)) vorliegen, zur Bestimmung einer Zeitdauer (t) des Zeitintervalls ($\Delta t$) und Berechnung des Intervall-Kennwertes (Km) als Quotient aus dem integrierten Kennwert (Ki) des Zeitintervalls ($\Delta t$) und der Zeitdauer (t).

11. Verfahren nach einem der vorhergehenden Ansprüche, **gekennzeichnet durch** Wichtung der Intervall-Kennwerte (Km) in Abhängigkeit von dem Betriebszustand der Speicherbatterie.

12. Verfahren nach einem der vorhergehenden Ansprüche, **dadurch gekennzeichnet, dass** der Zusammenhang zwischen der entnehmbaren Ladungsmenge ($Q_R$) und den Intervall-Kennwerten (Km), dem Ladezustand (SOC) und der Batterietemperatur ($T_{Bat}$) mit empirisch oder rechnerisch ermittelten Kennfeldern beschrieben ist.

13. Verfahren nach einem der vorhergehenden Ansprüche, **gekennzeichnet durch**

   - Anlernen eines Kennfeldes für Neuzustand-Intervall-Kennwerte ($Km_{neu}$) einer Speicherbatterie im Neuzustand in Abhängigkeit von Ladezuständen (SOC) und Batterietemperaturen ($T_{Bat}$),
   - Berechnen einer Maßzahl (J) aus einem Intervall-Kennwert (Km) bei einem ermittelten Ladezustand (SOC) und einer ermittelten Batterietemperatur ($T_{Bat}$) und aus dem Neuzustand-Intervall-Kennwert ($Km_{neu}$) für den Ladezustand (SOC) und die Batterietemperatur ($T_{Bat}$),
   - Ermitteln der entnehmbaren Ladungsmenge ($Q_R$) in Abhängigkeit von der Maßzahl (J) und dem Ladezustand (SOC) sowie der Batterietemperatur ($T_{Bat}$).

14. Verfahren nach Anspruch 13, **dadurch gekennzeichnet, dass** die Maßzahl (J) die Differenz von dem Intervall-Kennwert (Km) und dem Neuzustand-Intervall-Kennwert ($Km_{neu}$) ist.

15. Verfahren nach Anspruch 13, **dadurch gekennzeichnet, dass** die Maßzahl (J) das Verhältnis von dem Intervall-Kennwert (Km) und dem Neuzustand-Intervall-Kennwert ($Km_{neu}$) ist.

16. Überwachungseinrichtung für eine Speicherbatterie mit Messmitteln zur Messung von Batteriespannungen (U(t)) und Batterieströmen (I(t)), und mit Auswertemitteln, **dadurch gekennzeichnet, dass** die Auswertemittel zur Durchführung aller Schritte des Verfahrens nach einem der vorhergehenden Ansprüche ausgebildet sind.

**Claims**

1. Method for determining the amount of charge ($Q_R$) which can be drawn from a storage battery,

   - determination of the battery voltage (U(t)) and battery current (I(t)) over at least one time interval ($\Delta t$),

   **characterized by**

   - smoothing of the measured battery voltage profile (U(t)) and battery current profile (I(t)) using at least two different smoothing measures,
   - formation of the voltage differences ($\Delta U_{23}(t)$) of the battery voltages (U(t)) smoothed using a first smoothing measure and the battery voltages (U(t)) smoothed using a second smoothing measure, with the second smoothing measure producing greater smoothing than the first smoothing measure,
   - formation of the current differences ($\Delta I_{23}(t)$) of the battery currents (I(t)) smoothed using a first smoothing measure and the battery currents (I(t)) smoothed using a second smoothing measure, with the second smoothing measure producing greater smoothing than the first smoothing measure,
   - calculation of characteristic values (K(t)) from the quotients of the voltage differences ($\Delta U_{23}(t)$) and the current differences ($\Delta I_{23}(t)$),
   - calculation of the respective characteristic values (K(t)) for a time interval ($\Delta(t)$) into an interval characteristic value (Km) by the formation of the mean value of the characteristic value (K(t)) of a time interval ($\Delta t$), and
   - determination of the amount of charge ($Q_R$) which can be drawn from at least one interval characteristic value (Km) for at least one time interval ($\Delta t$), as a function of the state of charge (SOC) of the storage battery and of the battery temperature ($T_{Bat}$).

2. Method according to Claim 1, **characterized in that** the smoothing is carried out by filtering with different time

constants ($\tau$), with a second time constant ($\tau_2$) as a first smoothing measure being greater than a third time constant ($\tau_3$) as a second smoothing measure.

3. Method according to Claims 1 or 2, **characterized in that** the smoothing is at least partially carried out by averaging.

4. Method according to one of Claims 1 to 3, **characterized in that** the characteristic values (K(t)) are calculated or are used for determination of the interval characteristic value (Km) only when the magnitude of the current difference ($\Delta I_{23}(t)$) is less than a defined second limit value ($I_{grenz2}$).

5. Method according to Claim 4, **characterized in that** the second limit value ($I_{grenz2}$) is in the region of the 30-hour to 80-hour current, and preferably corresponds approximately to the 50-hour current of the storage battery.

6. Method according to one of Claims 1 to 5, **characterized in that** the characteristic values (K(t)) are calculated or are used for determination of the interval characteristic value (Km) only when the magnitude of the current difference ($\Delta I_{12}(t)$) of the battery current (I(t)) smoothed using the first smoothing measure and of the battery current (I(t)) smoothed using a second smoothing measure is less than a defined first limit value ($I_{grenz1}$), with the second smoothing measure producing greater smoothing than the first smoothing measure.

7. Method according to Claim 6, **characterized in that** the first limit value ($I_{grenz1}$) is in the region of the 30-hour to 80-hour current, and preferably corresponds approximately to the 50-hour current of the storage battery.

8. Method according to one of the preceding claims, **characterized in that** the characteristic values (K(t)) are calculated or are used for determination of the interval characteristic value (Km) only when the battery currents (I(t)) smoothed using the first smoothing measure are greater than a third limit value ($I_{grenz3}$) and are less than a fourth limit value ($I_{grenz4}$).

9. Method according to Claim 8, **characterized in that** the third limit value ($I_{grenz3}$) is approximately the 10-hour current, and the fourth limit value ($I_{grenz4}$) is approximately the 30-hour current.

10. Method according to one of claims 6 to 9, **characterized by** integration of the permissible characteristic values (K(t)) in a time interval ($\Delta t$) in order to calculate an integrated characteristic value (Ki) for the time interval ($\Delta t$), and integration of the times in which permissible characteristic values (K(t)) are present, in order to determine a time period (t) for the time interval ($\Delta t$) and to calculate the interval characteristic value (Km) as the quotient of the integrated characteristic value (Ki) of the time interval ($\Delta t$) and the time period (t).

11. Method according to one of the preceding claims, **characterized by** weighting of the interval characteristic values (Km) as a function of the state of operation of the storage battery.

12. Method according to one of the preceding claims, **characterized in that** the relationship between the amount of charge ($Q_R$) which can be drawn and the interval characteristic values (Km), the state of charge (SOC) and the battery temperature ($T_{Bat}$) are described using families of characteristics which are determined empirically or by calculation.

13. Method according to one of the preceding claims, **characterized by**

- learning of a family of characteristics or new state interval characteristic values ($Km_{neu}$) for a storage battery in the new state as a function of states of charge (SOC) and battery temperatures ($T_{Bat}$),
- calculation of a measure coefficient (J) from an interval characteristic value (Km) for a determined state of charge (SOC) and a determined battery temperature ($T_{Bat}$) and from the new state interval characteristic value ($Km_{neu}$) for the state of charge (SOC) and the battery temperature ($T_{Bat}$),
- determination of the amount of charge ($Q_R$) which can be drawn, as a function of the measure coefficient (J) and the state of charge (SOC), as well as the battery temperature ($T_{Bat}$).

14. Method according to Claim 13, **characterized in that** the measure coefficient (J) is the difference between the interval characteristic value (Km) and the new state interval characteristic value ($Km_{neu}$).

15. Method according to Claim 13, **characterized in that** the measure coefficient (J) is the ratio of the interval characteristic value (Km) and the new state interval characteristic value ($Km_{neu}$).

16. Monitoring device for a storage battery having measurement means for measurement of battery voltages (U(t)) and battery currents (I(t)), and having evaluation means, **characterized in that** the evaluation means are designed to carry out the method according to one of the preceding claims.

**Revendications**

1. Procédé pour déterminer la charge résiduelle ($Q_R$) disponible dans une batterie, selon lequel

   - on détermine la tension de batterie (U(t)) et le courant de batterie (I(t)) dans au moins un intervalle de temps ($\Delta t$),

   procédé **caractérisé en ce que**

   - on lisse la courbe de tension de batterie (U(t)) et la courbe de courant de batterie (I(t)) mesurées avec au moins deux moyens de lissage différents,
   - on forme la différence de tension ($\Delta U_{23}(t)$) des tensions de batterie (U(t)) lissées par un premier moyen de lissage et des tensions de batterie (U(t)) lissées par un second moyen de lissage, le second moyen de lissage assurant un lissage plus important que le premier moyen de lissage,
   - on forme les différences d'intensité ($\Delta I_{23}(t)$) des courants de batterie (I(t)) lissés par un premier moyen de lissage et les courants de batterie (I(t)) lissés par un second moyen de lissage, le second moyen de lissage assurant un lissage plus important que le premier moyen de lissage,
   - on calcule les valeurs caractéristiques (K(t)) des quotients des différences de tension ($\Delta U_{23}(t)$) et des différences d'intensité ($\Delta I_{23}(t)$),
   - on calcule chaque fois les valeurs caractéristiques (K(t)) d'un intervalle de temps ($\Delta(t)$) par rapport à une valeur caractéristique de l'intervalle (Km) en formant la valeur moyenne des valeurs caractéristiques (K(t)) d'un intervalle de temps ($\Delta(t)$), et
   - on détermine la charge ($Q_R$) disponible à partir d'au moins une valeur caractéristique de l'intervalle (Km) pour au moins un intervalle de temps (At) en fonction de l'état de charge (SOC) de la batterie et de sa température ($T_{Bat}$).

2. Procédé selon la revendication 1,
   **caractérisé en ce qu'**
   on effectue le lissage en filtrant avec des constantes de temps différentes ($\tau$), la seconde constante de temps ($\tau_2$) comme premier moyen de lissage étant plus grande qu'une troisième constante de temps ($\tau_3$) comme second moyen de lissage.

3. Procédé selon la revendication 1 ou 2,
   **caractérisé en ce que**
   le lissage se fait au moins en partie en formant une valeur moyenne.

4. Procédé selon l'une des revendications 1 à 3,
   **caractérisé en ce qu'**
   on ne calcule les valeurs caractéristiques (K(t)) ou on les utilise pour déterminer la valeur caractéristique de l'intervalle (Km) que si l'amplitude de la différence d'intensité ($\Delta I_{23}(t)$) est inférieure à une seconde valeur limite, fixée, ($I_{grenz2}$).

5. Procédé selon la revendication 4,
   **caractérisé en ce que**
   la seconde valeur limite ($I_{grenz2}$) se situe dans une plage de courant de 30 à 80 heures et de préférence elle correspond à un courant de 50 heures fourni par la batterie.

6. Procédé selon l'une des revendications 1 à 5,
   **caractérisé en ce qu'**
   on ne calcule les valeurs caractéristiques (K(t)) ou on ne les utilise pour déterminer la valeur caractéristique de l'intervalle (Km) que si l'amplitude de la différence d'intensité ($\Delta I_{12}(t)$) du courant de batterie (I(t)) lissée par le premier moyen de lissage et du courant de batterie (I(t)) lissé par un second moyen de lissage, est inférieure à une première valeur limite fixée ($I_{grenz1}$),
   le second moyen de lissage assurant un lissage plus important que le premier moyen lissage.

**7.** Procédé selon la revendication 6,
**caractérisé en ce que**
la première valeur limite ($I_{grenz1}$) se situe dans une plage d'un courant de 30 heures à 80 heures et de préférence elle correspond à un courant d'environ 50 heures fourni par la batterie.

**8.** Procédé selon l'une des revendications précédentes,
**caractérisé en ce qu'**
on ne calcule les valeurs caractéristiques ($K(t)$) ou on ne les utilise pour déterminer la valeur caractéristique de l'intervalle ($Km$), que si le courant de batterie ($I(t)$) lissé avec le premier moyen de lissage est supérieur à une troisième valeur limite ($I_{grenz3}$) et inférieur à une quatrième valeur limite ($I_{grenz4}$).

**9.** Procédé selon la revendication 8,
**caractérisé en ce que**
la troisième valeur limite ($I_{grenz3}$) est un courant d'environ 10 heures et la quatrième valeur limite ($I_{grenz4}$) est un courant d'environ 30 heures.

**10.** Procédé selon l'une des revendications 6 à 9,
**caractérisé par**
l'intégration des valeurs caractéristiques autorisées ($K(t)$) dans un intervalle de temps ($At$) pour calculer une valeur caractéristique intégrée ($Ki$) sur l'intervalle de temps ($At$) et l'intégration des temps dans lesquels il y a des valeurs caractéristiques autorisées ($K(t)$), pour déterminer une durée ($t$) de l'intervalle de temps ($At$) et calculer la valeur caractéristique de l'intervalle ($Km$) comme quotient de la valeur caractéristique intégrée ($Ki$) de l'intervalle de temps ($At$) et de la durée ($t$).

**11.** Procédé selon l'une des revendications précédentes,
**caractérisé par**
la pondération des valeurs caractéristiques de l'intervalle ($Km$) selon l'état de fonctionnement de la batterie.

**12.** Procédé selon l'une des revendications précédentes,
**caractérisé en ce que**
la relation entre la charge disponible ($Q_R$) et les valeurs caractéristiques de l'intervalle ($Km$) pour la charge ($SOC$), la tension de batterie ($T_{Bat}$) se décrivant avec des champs de caractéristiques obtenus de manière empirique ou par le calcul.

**13.** Procédé selon l'une des revendications précédentes,
**caractérisé en ce qu'**

- on apprend un champ de caractéristiques pour les caractéristiques de l'intervalle à l'état neuf ($Km_{neu}$) d'une batterie d'accumulateurs à l'état neuf en fonction des états de charge ($SOC$) et de la température de batterie ($T_{Bat}$),
- on calcule un nombre ($J$) représentant une mesure à partir d'une valeur caractéristique de l'intervalle ($Km$) pour un état de charge obtenu ($SOC$) et d'une température déterminée de la batterie ($T_{Bat}$) et à partir de la valeur caractéristique de l'intervalle à l'état neuf ($Km_{neu}$) de l'état de charge ($SOC$) et de la température de batterie ($T_{Bat}$),
- on détermine la charge résiduelle disponible ($Q_R$) en fonction du nombre de mesures ($J$) et de l'état de charge ($SOC$) ainsi que de la température de batterie ($T_{Bat}$).

**14.** Procédé selon la revendication 13,
**caractérisé en ce que**
le nombre ($J$) est la différence entre la valeur caractéristique de l'intervalle ($Km$) et la valeur caractéristique de l'intervalle à l'état neuf ($Km_{neu}$).

**15.** Procédé selon la revendication 13,
**caractérisé en ce que**
le nombre ($J$) représente le rapport entre la valeur caractéristique de l'intervalle ($Km$) et la valeur caractéristique de l'intervalle à l'état neuf ($Km_{neu}$).

**16.** Installation de surveillance d'une batterie comportant des moyens de mesure pour mesurer les tensions de batterie (U(t)) et des courants de batterie (I(t)) ainsi que des moyens d'exploitation,
**caractérisée en ce que**
les moyens d'exploitation sont réalisés pour exécuter toutes les étapes du procédé selon l'une des revendications précédentes.

Fig. 1

Strom I

Spannung U

Zeitkonstante t1

Zeitkonstante t2

Zeitkonstante t3

Zeitkonstante t2

Zeitkonstante t3

It1    It2    It3

Ut2    Ut3

$|It1-It2| < Igrenz1$ ?
$|It2-It3| < Igrenz2$ ?
$Igrenz3 < It2 < Igrenz4$ ?
$It2<0$ ?

Ja

Nein

Nein

$K=(Ut3-Ut2)/(It3-It2)$

$Ki = \int K \cdot dt$
$T = \int dt$

$Km=Ki/T$

Ende des Meßintervalls ?

Nein

Ja

Bewertung Km in Abhängigkeit von SOC und Tbat
Aussage über noch verfügbare Kapazität QR

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5761072 A
- DE 69423918 T2
- DE 69131276 T2
- US 5721688 A
- US 5572136 A
- US 6252377 B